# EUROPÄISCHE PATENTSCHRIFT

(11) **EP 3 265 878 B1**
(45) Veröffentlichungstag und Bekanntmachung des Hinweises auf die Patenterteilung: **10.04.2019**
(21) Anmeldenummer: 16707766.8
(22) Anmeldetag: 03.03.2016
(51) Int. Cl.: G03F 7/00, G03F 7/027, G03F 7/029, G03F 7/038, B29C 67/00

(54) **VERFAHREN ZUR HERSTELLUNG EINER DREIDIMENSIONALEN STRUKTUR UNTER VERWENDUNG ZWEIER PRÄ-STÜTZMATERIALIEN**
METHOD FOR PRODUCING A TRIDIMENSIONAL STRUCTURE USING TWO PRE-SUPPORTING MATERIALS
PROCÉDÉ DE FABRICATION D'UNE STRUCTURE TRIDIMENSIONNELLE AU MOYEN DE DEUX PRÉMATIÈRES SUPPORTS

(30) Priorität: 03.03.2015 EP 15157414
(43) Veröffentlichungstag der Anmeldung: 10.01.2018
(73) Patentinhaber: BASF SE, 67056 Ludwigshafen (DE)
(72) Erfinder: FLEISCHHAKER, Friederike, 67065 Ludwigshafen (DE); BEM, Valeria, 68163 Mannheim (DE); FUCHS, Andre, 79418 Schliengen-Obereggenen (DE)
(74) Vertreter: BASF IP Association
(86) Internationale Anmeldenummer: PCT/EP2016/054498
(87) Internationale Veröffentlichungsnummer: WO 2016/139287

(56) Entgegenhaltungen:
- EP-A1- 2 636 511
- WO-A1-2004/009364
- WO-A2-2010/132392
- US-A1- 2013 273 376

## Beschreibung

Die vorliegende Erfindung betrifft ein Verfahren zur Herstellung einer dreidimensionalen Struktur durch dreidimensionales Drucken unter Verwendung eines Stützmaterials, das den Erhalt exakter Konturen und einer glatten Oberfläche und eine vollständige und einfache Entfernung des Stützmaterials erlaubt.

Dreidimensionale (3D-)Druckverfahren dienen meist dem schnellen Prototypenbau ("Rapid Prototyping"). Es handelt sich um eine einstückige Herstellung von Strukturen, wodurch auf ein späteres Zusammenfügen von Einzelteilen zur Herstellung komplexer Strukturen verzichtet werden kann.

Das erste 3D-Druckverfahren wurde 1984 von Chuck Hull entwickelt, der seine Methode als Stereolithographie-Verfahren, kurz SL-Verfahren, bezeichnete. Beim SL-Verfahren wird ein in einer Ebene flächig als Schicht aufgetragener, lichtaushärtender Kunststoff von einem Laser ortsselektiv ausgehärtet. Die Prozedur erfolgt in einem Bad, welches mit einem flüssigen oder pastösen Basismonomer des lichtempfindlichen Kunststoffes gefüllt ist. Die sich aufgrund der Initiierung mit Laserlicht ortsselektiv ausbildenden Strukturbereiche in der Arbeitsebene werden in einem nächsten Schritt um den Betrag einer Schichtstärke nach unten in das Bad gefahren, so dass sich erneut eine Kunststoffschicht über den verfestigten Strukturbereichen innerhalb der Arbeitsebene ausbilden kann.

Beispielsweise ist aus der DE 100 24 618 A1 ein derartiges stereolithographisches Verfahren zur Erzeugung dreidimensionaler Strukturen bekannt, in dem flüssige bis gelartige Silikonkautschuke mit IR-Laser bestrahlt werden. Die US 2009/0224438 beschreibt die schichtweise Prozessierung von 3D-Objekten mittels SL-Verfahren mit mittels UV- oder Vis-Licht photovernetzbaren Materialien.

SL-Verfahren weisen unter anderem den Nachteil auf, dass nur ein einziges photovernetzbares Material für den Aufbau einer dreidimensionalen Struktur verwendet werden kann. Dadurch sind auch beispielsweise Grenzen hinsichtlich der elastischen Struktureigenschaften gesetzt.

Ein weiteres 3D-Druckverfahren wurde am Massachusetts Institute of Technology entwickelt. Dabei werden beispielsweise pulverförmige Polymere schichtweise auf eine Trägerplatte aufgebracht. Mittels eines Tintenstrahldruckers werden Bindemittel in jeder Schicht an den Stellen aufgespritzt, die verfestigt werden sollen. Ein solches Verfahren ist beispielsweise in der EP 0 431 924 B1 und US 5,387,380 beschrieben.

Ferner kann das so genannte Photopolymer-Jetting-Verfahren (auch als PolyJet-Verfahren bekannt) zur Herstellung dreidimensionaler Strukturen verwendet werden. Hier wandert, ähnlich einem Zeilendrucker, ein Druckblock mit einem oder mehreren Druckköpfen auf einer x-Achse vor und zurück und hinterlässt auf einer Bauplattform dünne Photopolymer-Schichten. Jede Schicht wird unmittelbar nach dem Auftragen mithilfe von UV-Lampen gehärtet, die direkt am Druckblock installiert sind.

Photopolymer-Jetting erlaubt unter Verwendung von gegebenenfalls mehreren unterschiedlichen Materialien ein Fertigen dreidimensionaler Teile mit einem hohen Grad an Geometriefreiheit und variablen materiellen Eigenschaften, wie beispielsweise der Elastizität.

So beschreibt die US 6,658,314 B1 ein Verfahren zur Herstellung einer dreidimensionalen Struktur, bei dem zwei Photopolymere in verschiedenen Verhältnissen gemischt werden, um gezielt die Elastizität der dreidimensionalen Struktur zu beeinflussen.

Die Erzeugung von überhängenden Strukturen und Hohlräumen ist allerdings nicht ohne weiteres möglich, da aufgrund des schichtweisen Aufbaus überhängende Bestandteile und Strukturen oberhalb von Hohlräumen nicht mit der darunterliegenden Schicht verbunden wären. Derartige Strukturen können aber stabilisiert werden, in dem neben dem Objektmaterial ein Stützmaterial aufgetragen wird, welches üblicherweise nach der Fertigstellung im wässrigen Medium entfernt werden kann. (siehe 55148)

So beschreibt die US 6,863,859 B2 eine als Stützmaterial geeignete, ein temperaturempfindliches Polymer umfassende Zusammensetzung und ein Verfahren zur Herstellung dreidimensionaler Strukturen unter Verwendung der Stützmaterial-Zusammensetzung, bei der das Stützmaterial im Anschluss an die Herstellung im wässrigen Medium entfernt wird.

Die US 2010/0256255 A1 beschreibt Stützmaterialien, welche mindestens ein dendritisches Oligomer, mindestens ein mono-funktionelles Monomer und ein reaktives Amin umfassen.

Die WO 2012/116047 A1 beschreibt Stützmaterialien, welche mindestens einen ethoxylierten Fettalkohol umfassen, und ihre Verwendung in 3D-Druckverfahren. Die WO 01/68375 A2 beschreibt Stützmaterialien, welche mindestens eine reaktive Komponente wie beispielsweise Acrylate oder Vinylether und einen Photoinitiator umfasst, und ihre Verwendung in 3D-Druckverfahren.

Die EP 2 636 511 A1 beschreibt ein 3D-Druckverfahren, bei dem aus einem ersten Druckkopf ein Objektmaterial ausgestoßen wird und aus einem zweiten Druckkopf ein Stützmaterial ausgestoßen wird. Objekt- und Stützmaterial werden strahlungsgehärtet und die Verfahrensschritte wiederholt, um eine dreidimensionale Struktur auszubilden.

Üblicherweise sind sowohl das Objektmaterial als auch das Stützmaterial radikalisch vernetzbar bzw. polymerisierbar. Dadurch können sich in Bereichen, in denen Objekt- und Stützmaterial aneinander grenzen, Mischprodukte ausbilden. So kann es zu unscharfen Grenzen zwischen Objekt- und Stützmaterial kommen und das Bauteil muss z. B. mechanisch nachbehandelt werden, um Stützmaterial-Reste zu entfernen und die Oberfläche der dreidimensionalen Struktur zu glätten.

Der vorliegenden Erfindung liegt daher die Aufgabe zugrunde, ein Verfahren zur Herstellung einer dreidimensionalen Struktur durch dreidimensionales Drucken unter Verwendung eines Stützmaterials, das den Erhalt exakter Konturen und einer glatten Oberfläche und eine vollständige und einfache Entfernung des Stützmaterials erlaubt, bereitzustellen.

Die Aufgabe wird durch ein Verfahren zur Herstellung einer dreidimensionalen Struktur durch dreidimensionales Drucken gelöst, das folgende Schritte umfasst:
a) Ausstoßen eines Objektmaterials aus einem ersten Druckkopf;
b) Ausstoßen eines ersten Prä-Stützmaterials aus einem zweiten Druckkopf; und
b') Ausstoßen eines zweiten Prä-Stützmaterials aus einem dritten Druckkopf
   wobei die Prä-Stützmaterialien flüssige Komponenten umfassen, die beim Zusammentreffen ein festes Stützmaterial bilden;
c) Strahlungshärten des Objektmaterials;
   wobei die Schritte a) bis c) mehrfach wiederholt werden, um schichtweise die dreidimensionale Struktur auszubilden und das Objektmaterial und das Stützmaterial wenigstens eine gemeinsame Grenzfläche aufweisen; und
d) Entfernen des verfestigten Stützmaterials durch Behandlung mit einem wässrigen Medium.

Das Stützmaterial wird aus zwei flüssigen, beim Zusammentreffen fest werdenden Komponenten erzeugt. Die Ausbildung der Stützstruktur interferiert nicht mit der Ausbildung der Gerüststruktur. Eine Reaktion zwischen Stützmaterial und Objektmaterial tritt zumindest stark vermindert auf und wird bevorzugt gänzlich verhindert. Dies bewirkt, dass eine nachträgliche Bearbeitung der Oberfläche der dreidimensionalen Struktur zur Entfernung von Resten des Stützmaterials nicht oder in stark verringertem Ausmaß notwendig ist.

Es ist auch möglich, das Stützmaterial in Form einer Trennschicht auszustoßen. Die eigentliche Stützung erfolgt dann durch ein Sekundärstützmaterial. In einer Ausführungsform umfasst das Verfahren daher die folgenden Schritte:
b) Ausstoßen eines ersten Prä-Stützmaterials aus einem zweiten Druckkopf; und
b') Ausstoßen eines zweiten Prä-Stützmaterials aus einem dritten Druckkopf
   wobei die Prä-Stützmaterialien flüssige Komponenten umfassen, die beim Zusammentreffen fest werden und ein Stützmaterial in Form einer Trennschicht bilden; und das Verfahren außerdem umfasst;
b") Ausstoßen eines Sekundärstützmaterials aus einem vierten Druckkopf;
   wobei die Schritte a), b), b'), b") und c) mehrfach wiederholt werden, um schichtweise die dreidimensionale Struktur auszubilden und das Stützmaterial und das Sekundärstützmaterial wenigstens eine gemeinsame Grenzfläche aufweisen;
d) Entfernen des verfestigten Stützmaterials und des gehärteten Sekundärstützmaterials durch Behandlung mit einem wässrigen Medium.

Vorzugsweise beträgt die Viskosität des Objektmaterials, der Prä-Stützmaterialien und, falls vorhanden, des Sekundärstützmaterials weniger als 20 mPas bei 70 °C. Üblicherweise beträgt die Viskosität 8 bis weniger als 20 mPas bei 70 °C, besonders bevorzugt 8 bis 15 mPas bei 70 °C. Da eine Tröpfchenbildung im Druckkopf nur bis zu einer bestimmten Viskosität möglich ist, wäre eine höhere Viskosität nachteilig.

### Objektmaterial

In einer Ausführungsform umfasst das Objektmaterial wenigstens eine radikalisch härtbare Verbindung. Die radikalisch härtbare Verbindung weist wenigstens eine ethylenisch ungesättigte Doppelbindung auf. Geeignete radikalisch härtbare Verbindungen umfassen monofunktionelle Verbindungen (Verbindungen mit einer ethylenisch ungesättigten Doppelbindung), polyfunktionelle Verbindungen (Verbindungen mit zwei oder mehreren ethylenisch ungesättigten Doppelbindungen), wozu ethylenisch ungesättigte Präpolymere zählen. Vorzugsweise umfasst die radikalisch härtbare Verbindung wenigstens eine polyfunktionelle Verbindung. Monofunktionelle Verbindungen können aufgrund ihrer niedrigen Viskosität z. B. als Reaktivverdünner mitverwendet werden.

Beispiele von monomeren monofunktionellen Verbindungen umfassen (Meth)acrylverbindungen und Vinylverbindungen.

Zu den (Meth)acrylverbindungen zählen:
C₁-C₁₈-Alkyl(meth)acrylate, wie Methylacrylat, Ethylacrylat, Butylacrylat, 2-Ethylhexylacrylat, Isobornylacrylat, Methylmethacrylat, Ethylmethacrylat, Butylmethacrylat; C₂-C₁₈-Hydroxyalkyl(meth)acrylate, wie 2-Hydroxyethyl(meth)acrylat, 2-Hydroxyethylmethacrylat, 4-Hydroxybutylacrylat; C₁-C₁₀-Alkoxy-C₂-C₁₈-alkyl(meth)acrylate, wie 2-Methoxyethyl(meth)acrylat, 2-Ethoxyethyl(meth)acrylat; Aryloxyalkyl(meth)acrylate, wie Phenoxyethylmethacrylat, p-Cumyl-phenoxyethylmethacrylat; C₇-C₂₀-Aralkyl-(meth)acrylate, wie Benzyl(meth)acrylat; C₂-C₇-Heterocyclyl(meth)acrylate, wie Tetrahydrofurfuryl(meth)acrylat; C₂-C₇-Heterocyclyl-C₂-C₁₀-alkyl(meth)acrylat, wie 2-N-Morpholinoethyl(meth)acrylat, 2-(2-Oxo-1-imidazolidinyl)ethyl(meth)acrylat; C₂-C₁₀-Aminoalkyl(meth)acrylate, wie 2-Aminoethyl(meth)acrylat ; Mono- oder Di-C₁-C₁₀-Alkyl-C₂-C₁₀-aminoalkyl(meth)acrylate, wie 2-(Dimethylamino)ethyl(meth)acrylat, 2-(Diethylamino)ethyl(meth)acrylat, 2-(Diisopropylamino)ethyl(meth)acrylat, 2-(tert-Butylamino)ethyl(meth)acrylat; (Meth)acrylnitril; (Meth)acrylamid; C₂-C₃₀-Alkyl-(meth)acrylamide, wie N-n-Butyl(meth)acrylamid, N-tert-Butyl(meth)acrylamid, N-Octyl(meth)acrylamid, N-Lauryl(meth)acrylamid, N-1-Methylundecyl(meth)acrylamid, N-2-Ethylhexyl(meth)acrylamid und N-tert-Octyl(meth)acrylamid; C₂-C₁₈-Hydroxyalkyl-(meth)acrylamide, wie N-Hydroxyethyl(meth)acrylamid, N-[Tris(hydroxymethyl)methyl]-(meth)acrylamid; C₁-C₁₀-Alkoxy-C₁-C₁₈-alkyl(meth)acrylamide, wie N-(3-Methoxypropyl)(meth)acrylamid, N-(Butoxymethyl)(meth)acrylamid, N-(Isobutoxymethyl)-(meth)acrylamid; C₂-C₇-Heterocyclyl(meth)acrylamide, wie N-Tetrahydrofurfuryl-(meth)acrylamid; C₂-C₇-Heterocyclyl-C₂-C₁₀-alkyl(meth)acrylamide, wie N-(2-N-Morpholinoethyl)(meth)acryamid, N-(2-(2-Oxo-1-imidazolidinyl)ethyl)(meth)acrylamid; C₂-C₁₀-Aminoalkyl(meth)acrylamide, wie N-(3-Aminopropyl)(meth)acrylamid; und Mono- oder Di-C₁-C₁₀-Alkyl-C₂-C₁₀-aminoalkyl(meth)acrylamide, wie N-[2-(Dimethyl-amino)ethyl](meth)acrylamid, N-[3-(Dimethylamino)propyl](meth)acrylamid.

Unter diesen sind N-verzweigtes Alkyl(meth)acrylamid wie N-tert-Butyl(meth)acrylamid, N-tert-Octyl(meth)acrylamid und N-2-Ethylhexyl(meth)acrylamid insbesondere bevorzugt.

Zu den Vinylverbindungen zählen Vinylester, wie Vinylacetat; N-Vinylamide, wie N-Vinylpyrrolidon; Vinylaromaten, wie Styrol, Alkylstyrole und Halogenstyrole; und Vinylhalogenide, wie Vinylchlorid und Vinylidenchlorid.

Beispiele von polyfunktionellen Verbindungen umfassen beispielsweise Ester von Polyolen mit ethylenisch ungesättigten Carbonsäuren, wie Acrylsäure, Methacrylsäure, Crotonsäure, Itaconsäure, Zimtsäure, Maleinsäure, Fumarsäure und ungesättigte Fettsäuren wie Linolsäure, Linolensäure oder Ölsäure. Bevorzugt sind Acrylsäure und Methacrylsäure.

Geeignete Polyole umfassen aromatische und insbesondere aliphatische und cycloaliphatische Polyole. Beispiele aromatischer Polyole umfassen Hydrochinon, 4,4'-Dihydroxybiphenyl, 2,2-Di-(4-hydroxyphenyl)-propan, sowie Novolake und Resole. Beispiele aliphatischer und cycloaliphatischer Polyole umfassen Alkylendiole, welche bevorzugt 2 bis 12 Kohlenstoffatome aufweisen, wie Ethylenglycol, 1,2- oder 1,3-Propandiol, 1,2-, 1,3- oder 1,4-Butandiol, Pentandiol, Hexandiol, Ocatndiol, Dodecandiol, Diethylenglycol, Triethylenglycol, Polyethylenglycole mit bevorzugten Molmassen von 200 bis 1.500 g/mol, 1,3-Cyclopentandiol, 1,2-, 1,3- oder 1,4-Cyclohexandiol, 1,4-Dihydroxymethylcyclohexan, Glycerin, Tris-(β-hydroxyethyl)-amin, Trimethylolethan, Trimethylolpropan, Pentaerythritol, Dipentaerythritol und Sorbitol. Weitere geeignete Polyole umfassen beispielsweise Polymere und Copolymere, welche Hydroxylgruppen in der Polymerkette oder in Seitenketten enthalten, wie Polyvinylalkohol und Copolymere davon, sowie Polyhydroxyalkylmethacrylate und Copolymere davon. Oligoester, welche Hydroxyl-Endgruppen beinhalten, sind ebenfalls geeignete Polyole.

Die Polyole können teilweise oder vollständig mit einer oder mehreren unterschiedlichen ungesättigten Carbonsäuren verestert sein, wobei die freien Hydroxylgruppen in partiellen Estern ggf. modifiziert wurden, z. B. verethert oder mit anderen Carbonsäuren verestert.

Beispiele von Estern umfassen Trimethylolpropantriacrylat, Trimethylolethantriacrylat, Trimethylolpropantrimethacrylat, Trimethylolethantrimethacrylat, Tetramethylenglycoldimethacrylat, Triethylenglycoldimethacrylat, Tetraethylenglycoldiacrylat, Pentaerythritoldiacrylat, Pentaerythritoltriacrylat, Pentaerythritoltetraacrylat, Dipentaerythritoldiacrylat, Dipentaerythritoltriacrylat, Dipentaerythritoltetraacrylat, Dipentaerythritolpentaacrylat, Dipentaerythritolhexaacrylat, Tripentaerythritoloctaacrylat, Pentaerythritoldimethacrylat, Pentaerythritoltrimethacrylat, Dipentaerythritoldimethacrylat, Dipentaerythritoltetramethacrylat, Tripentaerythritoloctamethacrylat, Pentaerythritoldiitaconat, Dipentaerythritoltrisitaconat, Dipentaerythritoltpentaitaconat, Dipentaerythritolthexaitaconat, Ethylenglycoldiacrylat, Hexamethylenglycoldiacrylat, 1,3-Butandioldiacrylat, 1,3-Butandioldimethacrylat, 1,4 Butandiol-diitaconat, Sorbitoltriacrylat, Sorbitoltetraacrylat, modifiziertes Pentaerythritoltriacrylat, Sorbitoltetramethacrylat, Sorbitolpentaacrylat, Sorbitolhexaacrylat, Oligoesteracrylate und -methacrylate, Bisphenol-A-diacrylate, Glyceroldiacrylate und -triacrylate, 1,4-Cyclohexandiacrylat, 4,4'-Bis-(2-acryloyloxyethoxy)-diphenylpropan, Bisacrylate und Bismethacrylate von Polyethylenglycol mit einer Molmasse im Bereich von 200 bis 1.500 g/mol, oder Gemische davon.

Weitere geeignete Ester umfassen Dipropylenglycoldiacrylat, Tripropylenglycoldiacrylat, 1,6-Hexandioldiacrylat, ethoxyliertes Glycerintriacrylat, propoxyliertes Glycerintriacrylat, ethoxyliertes Trimethylolpropantriacrylat, propoxyliertes Trimethylolpropantriacrylat, ethoxyliertes Pentaerythritoltetraacrylat, propoxyliertes Pentaerythritoltriacrylat, propoxyliertes Pentaerythritoltetraacrylat, ethoxyliertes Neopentylglycoldiacrylat, propoxyliertes Neopentylglycoldiacrylat.

Weitere Beispiele von polyfunktionellen Verbindungen umfassen Amide der vorhergehenden oder anderen ungesättigten Carbonsäuren mit aromatischen, cycloaliphatischen und aliphatischen Polyaminen, welche bevorzugt 2 bis 6, besonders bevorzugt 2 bis 4 Aminogruppen aufweisen. Beispiele derartiger Polyamine umfassen Ethylendiamin, 1,2- oder 1,3 Propylendiamin, 1,2-, 1,3- oder 1,4-Butylendiamin, 1,5-Pentylendiamin, 1,6 Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)-ethan. Weitere geeignete Polyamine sind Polymere und Copolymere, welche ggf. weitere Aminogruppen in den Seitenketten aufweisen, und Oligoamide mit terminalen Aminogruppen. Beispiele derartiger ungesättigter Amide umfassen: Methylenbisacrylamid, 1,6 Hexamethylenbisacrylamid, Diethylentriamintrismethacrylamid, Bis(methacrylamidopropoxy)ethan, β-Methacrylamidoethylmethacrylat und N-[(β-hydroxyethoxy)ethyl]-acrylamid.

Weitere Beispiele von polyfunktionellen Verbindungen umfassen Vinylacrylat, Divinylbenzol, Divinylsuccinat, Diallyphtalat, Triallylphosphat, Triallylisocyanurat,Tris-(2-acryloylethyl)-isocyanurat und Dicyclopentadienylacrylat.

Als Präpolymere sind Polymere geeignet, welche ethylenisch ungesättigte Gruppen in der Hauptkette oder als Seitengruppe enthalten oder damit terminiert sind, wie ungesättigte Polyester, Polyamide und Polyurethane und Copolymere davon, Polybutadien und Butadiencopolymere, Polyisopren und Isoprencopolymere, Polymere und Copolymere, welche (Meth)acrylatgruppen in den Seitenketten enthalten, sowie Gemische von einem oder mehreren derartigen Polymeren.

Geeignete ungesättigte Polyester und Polyamide werden beispielsweise aus Maleinsäure und Diolen oder Diaminen hergestellt. Die Polyester und Polyamide können auch aus Dicarbonsäuren und ethylenisch ungesättigten Diolen oder Diaminen, insbesondere relativ langkettigen, mit beispielsweise 6 bis 20 Kohlenstoffatomen, hergestellt werden. Weitere Beispiele von Polyestern umfassen ungesättigte Polyesterharze, welche im Allgemeinen aus Maleinsäure, Phthalsäure und einem oder mehreren Diolen hergestellt werden. Geeignete Polyester umfassen außerdem Alkydharze. Geeignete Polyamide sind beispielsweise Kondensate aus Polyaminen und ungesättigten dimeren Fettsäuren.

Beispiele von ungesättigten Polyurethanen umfassen solche, welche aus gesättigten Diisocyanaten und ungesättigten Diolen bzw. aus ungesättigten Diisocyanaten und gesättigten Diolen hergestellt werden.

Butadien, welches als Monomer für Polybutadien bzw. Butadien-Copolymere dient, polymerisiert in der Regel so, dass eine ethylenisch ungesättigte Gruppe als Teil der Hauptkette oder Seitenkette verbleibt. Gleiches gilt für Polyisopren, welches als Monomer für Polyisopren bzw. Isopren-Copolymere dient. Beispiele geeigneter Comonomere umfassen jeweils Olefine wie Ethen, Propen, Buten, Hexen, (Meth)acrylate, Acrylnitril, Styrol und Vinylchlorid.

Polymere, welche in der Seitenkette (Meth)acrylatgruppen enthalten, sind dem Fachmann bekannt. Sie umfassen beispielsweise Reaktionsprodukte von Novolak-basierten Epoxidharzen und (Meth)acrylsäure, Homopolymere oder Copolymere von Vinylalkohol oder die Hydroxyalkylderivate davon, welche mit (Meth)acrylsäure verestert wurden, und Homopolymere und Copolymere von (Meth)acrylaten, welche mit Hydroxyalkl(meth)acrylaten verestert wurden.

Copolymere, welche (Meth)acrylatgruppen als Seitengruppen enthalten, sind beispielsweise durch Funktionalisierung von Copolymeren mit (Meth)acrylsäure erhältlich. Bevorzugt erfolgt die Funktionalisierung von Copolymeren mit (Meth)acrylsäure. In diesen Verbindungen liegen die ethylenisch ungesättigten Doppelbindungen bevorzugt in Form von (Meth)acryloylgruppen vor. Bevorzugter Weise sind mindestens zwei polymerisierbare Doppelbindungen in Form von (Meth)acryloylgruppen im Molekül vorhanden. Die durchschnittliche Molmasse dieser Verbindungen kann beispielsweise im Bereich von 300 bis 10.000 g/mol liegen, bevorzugt im Bereich von 800 bis 10.000 g/mol.

Präpolymere können auch mit ethylenisch ungesättigten Verbindungen terminiert sein. Beispielsweise finden Maleat-terminierte Oligomere mit Polyester-, Polyurethan-, Polyether- und Polyvinylether-Hauptketten Verwendung. Weitere Beispiele für ethylenisch ungesättigt terminierte Prepolymere umfassen Urethan(meth)acrylate, Epoxy(meth)acrylate und acrylierte Epoxidharze.

Weitere besonders geeignete Verbindungen sind Urethan(meth)acrylate, welche durch Umsetzung von Polyisocyanaten mit Hydroxyalkyl(meth)acrylaten und gegebenenfalls Kettenverlängerungsmitteln wie Diolen, Polyolen, Diaminen, Polyaminen oder Dithiolen oder Polythiolen erhältlich sind. Hierzu zählen Urethan-Oligomere, die terminale und/oder seitliche (Meth)acrylgruppen tragen. Urethan-Oligomere werden herkömmlicherweise durch Umsetzung eines aliphatischen oder aromatischen Diisocyanats mit einem zweiwertigen Polyether oder Polyester, besonders typisch einem Polyoxyalkylenglycol, wie Polyethylenglycol, bereitgestellt. Solche Oligomere besitzen typischerweise 4 bis 10 Urethangruppen. Das aus dieser Umsetzung resultierende Isocyanatgruppen-terminierte Polyurethanpolymer wird dann mit (Meth)acrylsäure, einem (Meth)acrylamid oder mit einem (Meth)acrylsäureester, welcher eine Hydroxylgruppe aufweist, insbesondere mit einem Hydroxyalkyl-(meth)acrylat wie Hydroxypropylacrylat (HPA), Hydroxypropylmethacrylat (HPMA), Hydroxybutylacrylat (HBA) oder Hydroxybutylmethacrylat (HBMA) bevorzugt mit Hydroxyethylacrylat (HEA) oder Hydroxyethylmethacrylat (HEMA), oder mit einem Monohydroxypoly(meth)acrylat eines Polyols, bevorzugt von Glycerin oder Trimethylolpropan, zu einem Polyurethan(meth)-acrylat, umgesetzt.

Ein geeignetes Urethan(meth)acrylat ist z. B. UDMA (ein Additionsprodukt aus 2-Hydroxyethylmethacrylat und 2,2,4-Trimethylhexamethylendiisocyanat). Polyetherurethanacrylat-Oligomere bzw. Polyesterurethanacrylat-Oligomere sind z. B. Ebecryl 284 und CN 982, CN 982B10 und CN988 B88 von Sartomer.

Weitere besonders geeignete Verbindungen sind Epoxy(meth)acrylate, welche durch Umsetzung von Epoxiden mit (Meth)acrylsäure erhältlich sind. Als Epoxide in Betracht kommen z. B. epoxidierte Olefine, aromatische Glycidolether oder aliphatische Glycidolether, bevorzugt solche von aromatischen oder aliphatischen Glycidolethern. Ein geeignetes Epoxy(meth)acrylat ist z. B. Bis-GMA (ein Additionsprodukt aus Methacrylsäure und Bisphenol-A-diglycidylether).

Die radikalisch härtbare Verbindung liegt im Objektmaterial vorzugsweise in einer Menge von wenigstens 50 Gew.-%, besonders bevorzugt wenigstens 70 Gew.-%, bezogen auf das Gewicht des Objektmaterials vor.

Umfasst das Objektmaterial wenigstens eine radikalisch härtbare Verbindung, so umfasst es bevorzugt auch einen Photoinitiator. Photoinitiatoren sind photoaktive Substanzen, die bei Belichtung mit UV-Licht Radikale bilden und so eine radikalische Vernetzung oder Polymerisation auslösen können.

Als Photoinitiatoren können dem Fachmann bekannte Photoinitiatoren verwendet werden, z. B. die in "Advances in Polymer Science", Volume 14, Springer Berlin 1974 oder in K. K. Dietliker, Chemistry and Technology of UVand EB-Formulation for Coatings, Inks and Paints, Volume 3; Photoinitiators for Free Radical and Cationic Polymerization, P. K. T. Oldring (Eds), SITA Technology Ltd, London, genannten.

In Betracht kommen z. B. Mono- oder Bisacylphosphinoxide, wie sie z. B. in EP-A 7 508, EP-A 57 474, DE-A 196 18 720, EP-A 495 751 oder EP-A 615 980 beschrieben sind, beispielsweise 2,4,6-Trimethylbenzoyldiphenylphosphinoxid (Lucirin TPO), Bis(2,4,6-Trimethylbenzoyl)phenylphosphinoxid (Irgacure 819), Ethyl-2,4,6-trimethylbenzoylphenylphosphinat, Benzophenone, Hydroxyacetophenone, Phenylglyoxylsäure und ihre Derivate oder Gemische dieser Photoinitiatoren. Als Beispiele seien genannt Benzophenon, Acetophenon, Acetonaphthochinon, Methylethylketon, Valerophenon, Hexanophenon, [alpha]-Phenylbutyrophenon, p-Morpholinopropiophenon, Dibenzosuberon, 4-Morpholinobenzophenon, 4-Morpholinodeoxybenzoin, p-Diacetylbenzol, 4-Aminobenzophenon, 4'-Methoxyacetophenon, β-Methylanthrachinon, tert-Butylanthrachinon, Anthrachinoncarbonysäureester, Benzaldehyd, [alpha]-Tetralon, 9-Acetylphenanthren, 2-Acetylphenanthren, 10-Thioxanthenon, 3-Acetylphenanthren, 3-Acetylindol, 9-Fluorenon, 1-Indanon, 1,3,4-Triacetylbenzol, Thioxanthen-9-on, Xanthen-9-on, 2,4-Dimethylthioxanthon, 2,4-Diethylthioxanthon, 2,4-Di-iso-propylthioxanthon, 2,4-Dichlorthioxanthon, Benzoin, Benzoin-iso-butylether, Chloroxanthenon, Benzointetrahydropyranylether, Benzoin-methylether, Benzoinethylether, Benzoinbutylether, Benzoin-iso-propylether, 7-H-Benzoin-methylether, Benz[de]anthracen-7-on, 1-Naphthaldehyd, 4,4'-Bis(dimethylamino)benzophenon, 4-Phenylbenzophenon, 2-Chlorbenzophenon, 4-Chlorbenzophenon, Michlers Keton, 1-Acetonaphthon, 2-Acetonaphthon, 1-Benzoylcyclohexan-1-ol, 2-Hydroxy-2,2-dimethylacetophenon, 2,2-Dimethoxy-2-phenylacetophenon, 2,2-Diethoxy-2-phenylacetophenon, 1,1-Dichloracetophenon, 1-Hydroxyacetophenon, Acetophenondimethylketal, o-Methoxybenzophenon, Triphenylphosphin, Tri-o-Tolylphosphin, Benz[a]anthracen-7,12-dion, 2,2-Diethoxyacetophenon, Benzilketale, wie Benzildimethylketal, 2-Methyl-1-[4-(methylthio)phenyl]-2-morpholinopropan-1-on, Anthrachinone wie 2-Methylanthrachinon, 2-Ethylanthrachinon, 2-tert-Butylanthrachinon, 1-Chloranthrachinon, 2-Amylanthrachinon und 2,3-Butandion.

Unter den genannten Photoinitiatoren sind Phosphinoxide, α-Hydroxyketone und Benzophenone bevorzugt. Es können auch Gemische verschiedener Photoinitiatoren verwendet werden.

Im Allgemeinen liegt der Photoinitiator im Objektmaterial in einer Menge von 0,001 bis 15 Gew.-%, vorzugsweise 0,01 bis 10 Gew.-%, basierend auf dem Gesamtgewicht des Objektmaterials, vor.

Umfasst das Objektmaterial einen Photoinitiator, so umfasst es in der Regel auch einen Sensitizer, mit dem der Photoinitiator angeregt wird. Geeignete Sensitizer werden üblicherweise in Kombination mit wenigstens einem der obigen Photoinitiatoren verwendet. Eine bevorzugte Kombination umfasst einen Sensitizer, ausgewählt unter Thioxanthon, Benzophenon, Cumarin und Derivaten davon. Sensitizer werden bevorzugt in einer Menge im Bereich von 0,001 bis 15 Gew.-%, bevorzugt 0,01 bis 10 Gew.-%, bezogen auf das Gesamtgewicht des Objektmaterials verwendet.

Umfasst das Objektmaterial wenigstens eine radikalisch härtbare Verbindung, so umfasst es bevorzugt auch einen Stabilisator, der eine spontane oder thermisch unkontrollierte Polymerisationen des Objektmaterials unterdrückt. Geeignete Stabilisatoren sind z. B. Hydrochinone oder Monomethylhydrochinone. Stabilisatoren werden vorzugsweise in einer Menge von weniger als 500 ppm, bevorzugt weniger als 200 ppm, bevorzugt weniger als 100 ppm mitverwendet.

Das Objektmaterial kann geeigneter Weise einen Verdicker zur Einstellung einer geeigneten Viskosität enthalten. Geeignete Verdicker sind pyrogene Kieselsäure und laminare Silicate.

Das Objektmaterial kann daneben weitere übliche Bestandteile, wie Entschäumer, Fließhilfsmittel, Weichmacher, oberflächenaktive Substanzen, Pigmente, Dispergiermittel und dergleichen enthalten.

Für die Erfindung geeignete radikalisch härtbare Objektmaterialien sind im Handel erhältlich. Sie umfassen beispielsweise die von der Firma Stratasys hergestellten Vero-Materialien, Durus-Materialien, Tango-Materialien und FullCure-Materialien, z. B. FullCure 720.

In einer weiteren Ausführungsform umfasst das Objektmaterial eine kationisch polymerisierbare Verbindung. Als kationisch polymerisierbare Verbindung werden hier Verbindungen verstanden, bei denen die Neigung zur kationische Polymerisation gegenüber einer radikalischen Polymerisation stark bevorzugt ist.

Bei der kationischen Polymerisation wird als Initiator ein reaktives Kation, also eine Lewis- bzw. Brönstedt-Säure verwendet, welche in einer Startreaktion mit der Doppelbindung einer reaktiven Einheit reagiert. Es folgen Wachstumsreaktionen, bei der das aus der Startreaktion resultierende Kation an ein weiteres Monomer addiert, wodurch wiederum ein Kation entsteht.

Bevorzugt enthalten die kationisch polymerisierbaren Verbindungen keine ethylenisch ungesättigten Reste.

Als kationische polymerisierbare Verbindungen lassen sich kationisch polymerisierbare Monomere und Makromonomere wie z. B. Epoxide, Oxetane, Oxazoline, Lactone, Lactame, Vinylether, Furane, cyclische Ketenacetale, Spiroorthocarbonate, oder bicyclische Orthoester einsetzen. Bevorzugt umfasst das Objektmaterial eine kationische polymerisierbare Verbindung, welche ausgewählt ist unter Epoxiden, Vinylethern, Lactonen, Lactamen, Oxetanen und Oxazolinen.

Geeignete Epoxide sind vor allem Glycidylether oder cycloaliphatische Epoxide, wie Bisphenol-A-diglycidylether, 3,4-Epoxy-cyclohexylmethyl-3,4-epoxycyclohexan-carboxylat und Bis(3,4-epoxycyclohexylmethyl)adipat.

Geeignete Oxetane umfassen 2-Ethylhexyloxetan und 1,10-Decandiyl-bis-(oxymethylen)-bis-(3-ethyloxetan).

Geeignete Oxazoline sind ausgewählt unter 2-Phenyloxazolin und 2-Decyloxazolin.

Geeignete Lactone sind ausgewählt unter β-Propiolacton, γ-Butyrolacton, δ-Valerolacton und ε-Caprolacton.

Geeignete Lactame sind ausgewählt unter β-Propiolactam, γ-Butyrolactam, δ-Valerolactam, ε-Caprolactam und N-Methyl-2-pyrrolidon

Geeignete Vinylether umfassen (C₁₋₈-Alkyl)vinylether.

Geeignete Furane umfassen Furan, 3-(C₁₋₈-Alkyl)furane und 4-(C₁₋₈-Alkyl)furane.

Geeignete cyclische Ketenacetale umfassen 2-Methylen-1,3-dioxepan, 2-Phenyl-4-methylen-1,3-dioxolan.

Geeignete Spiroorthocarbonate umfassen 2-Methylen-1,4,6-trioxaspiro[2.2]-nonan und 3,9-Dimethylen-1,5,7,11-tetraoxaspiro[5.5]undecan.

In einer bevorzugten Ausführungsform umfasst das Objektmaterial wenigstens 80 Gew.-% der kationisch polymerisierbaren Verbindung, besonders bevorzugt wenigstens 90 Gew.-%, bezogen auf das Gesamtgewicht des Objektmaterials.

Umfasst das Objektmaterial wenigstens eine kationisch polymerisierbare Verbindung, so umfasst es bevorzugt auch einen Photosäuregenerator. Unter einem Photosäuregenerator wird eine Verbindung verstanden, welche unter Bestrahlung mit kurzwelligem Licht, beispielsweise UV-Bestrahlung, ein reaktives Kation (d. h. eine Lewis- bzw. Brönstedt-Säure) freisetzt.

Geeignete Photosäuregeneratoren umfassen ionische und insbesondere nicht-ionische Photosäuregeneratoren.

Ionische Photosäuregeneratoren werden von stabilen organischen Oniumsalzen, insbesondere solchen mit Stickstoff, Phosphor, Sauerstoff, Schwefel, Selen oder lod als zentralem Atom des Kations hergeleitet. Bevorzugt sind aromatische Sulfonium- und lodoniumsalze mit komplexen Anionen, Phenacylsulfoniumsalze, Hydroxyphenylsulfoniumsalze und Sulfoxoniumsalze.

Derartige ionische Photosäuregeneratoren umfassen beispielsweise die handelsüblichen Produkte der Bezeichnung Irgacure 250, Irgacure PAG 290 und GSID26-1 von BASF SE; Cyracure UVI-6990 und Cyracure UVI-6974 von Union Carbide; Degacure KI 85 von Degussa; Optomer SP-55, Optomer SP-150 und Optomer SP-170 von Adeka; GE UVE 1014 von General Electric, SarCat CD 1012; und SarCat KI-85, SarCat CD 1010 und SarCat® CD 1011 von Sartomer.

Nicht-ionische Photosäuregeneratoren umfassen Verbindungen, die bei einer Photolyse Carbonsäuren, Sulfonsäuren, Phosphorsäuren oder Wasserstoffhalogenide freisetzen, beispielsweise Nitrobenzylester, Sulfonsäure-Derivate, Phosphatester, Phenolsulfonatester, Diazonaphthochinon und N-Hydroxyimidosulfonat. Diese können alleine oder in Kombination verwendet werden. Bevorzugt sind Sulfonsäure-Derivate. Nicht-ionische Photosäuregeneratoren sind im Vergleich zu ionischen Photosäuregeneratoren in einem breiteren Bereich von Lösemitteln löslich.

Derartige nicht-ionische Photosäuregeneratoren umfassen beispielsweise N-Hydroxy-5-norbornen-2,3-dicarboximidperfluoro-1-butansulfonat, N-Hydroxynaphthalimidtriflat und 2-(4-Methoxystyryl)-4,6-bis(trichloromethyl)-1,3,5-triazin, sowie die handelsüblichen Produkte der Bezeichnung Irgacure PAG 103, Irgacure PAG 121, Irgacure PAG 203, CGI 725 und CGI 1907 von BASF SE.

Es können auch organische Siliziumverbindungen verwendet werden, die unter UV-Bestrahlung in Anwesenheit einer Aluminium-haltigen organischen Verbindung ein Silanol freisetzen.

Als Photosäuregeneratoren eignen sich auch solche, die mittels eines Sensitizers angeregt werden. Sensitizer werden bevorzugt in einer Menge im Bereich von 0,001 bis 15 Gew.-%, bevorzugt 0,01 bis 10 Gew.-% bezüglich des Gesamtgewichts des Objektmaterials verwendet.

Geeignete Sensitizer werden üblicherweise in Kombination mit wenigstens einem der obigen Photosäuregeneratoren verwendet. Bevorzugte Sensitizer sind polycyclische aromatische Verbindungen wie Anthracen, Naphthalen und ihre Derivate (sh. auch US 6,313,188, EP 0 927 726, WO 2006/073021, US 4,997,717, US 6,593,388 und WO 03/076491). Eine bevorzugte Kombination umfasst einen Sensitizer, ausgewählt unter polycyclischen aromatischen Verbindungen und einem nicht-ionischen Photosäuregenerator.

In einer bevorzugten Ausführungsform der vorliegenden Erfindung liegt im Objektmaterial der Photosäuregenerator in einer Menge von 0,001 bis 15 Gew.-%, besonders bevorzugt 0,01 bis 10 Gew.-%, vor.

In einer bevorzugten Ausführungsform ist das Objektmaterial frei von nicht-wässrigen Lösemitteln.

Das Objektmaterial kann geeigneter Weise einen Verdicker zur Einstellung einer geeigneten Viskosität enthalten. Geeignete Verdicker sind pyrogene Kieselsäure und laminare Silicate.

Das Objektmaterial kann daneben weitere übliche Bestandteile, wie Entschäumer, Fließhilfsmittel, Weichmacher, oberflächenaktive Substanzen, Pigmente, Dispergiermittel und dergleichen enthalten.

### Prä-Stützmaterialien

Das erfindungsgemäße Verfahren bedient sich zweier flüssiger Komponenten, die beim Zusammentreffen ein festes Stützmaterial bilden. Die Bildung eines festen Stützmaterials kann durch Gelieren und/oder Ausfällung eines Niederschlags erfolgen.

Geeignete Prä-Stützmaterialien sind flüssige Komponenten, bevorzugt mit einer Viskosität kleiner 20 mPas bei 70 °C, die sich über einen Druckkopf ausstoßen lassen. Diese Eigenschaften werden von niedermolekularen Polymeren und Polymerlösungen erfüllt.

Die Verfestigung der Prä-Stützmaterialien bei ihrem Zusammentreffen und die damit einhergehende Stabilisierung des Objektmaterials beruht auf einem Mechanismus, welcher sich vom radikalischen Mechanismus der Aushärtung des Objektmaterials unterscheidet. Dadurch wird eine Reaktion zwischen Prä-Stützmaterialien und Objektmaterial vermindert bzw. unterbunden und somit glattere Oberflächen nach der Entfernung der Stützmaterialien durch eine wässrige Lösung erreicht.

Geeigneter Weise beruht die Verfestigung der zusammengeführten Prä-Stützmaterialien auf nicht-kovalenten intermolekularen Wechselwirkungen zwischen den Prä-Stützmaterialien.

In einer Ausführungsform umfasst das erste Prä-Stützmaterial ein erstes Polymer, das eine Vielzahl positiv geladener Gruppen und/oder latent positiv geladener Gruppen aufweist oder eine Vielzahl an Protonenakzeptoren aufweist und das zweite Prä-Stützmaterial ein zweites Polymer, das eine Vielzahl negativ geladener Gruppen und/oder latent negativ geladener Gruppen aufweist oder eine Vielzahl an Protonendonatoren aufweist.

Eine latent geladene Gruppe ist eine funktionelle Gruppe, die durch Abgabe oder Aufnahme eines Protons in der Anwendungsumgebung in eine geladene Gruppe überführt werden kann. Protonendonatoren umfassen eine Vielzahl elektronegativer Atome, z. B. Stickstoff oder Sauerstoff, an welche ein Wasserstoffatom kovalent gebunden ist. Protonenakzeptoren umfassen eine Vielzahl von Atomen mit freien Elektronenpaaren.

Beim Zusammenbringen führen beispielsweise die Coulomb-Wechselwirkung und/oder Wasserstoffbrückenbindungen zwischen dem ersten Polymer und dem zweiten Polymer zur Verfestigung, zum Beispiel durch Gelieren und/oder Präzipitation. Durch die Coulomb-Wechselwirkung und/oder Wasserstoffbrückenbindungen werden die Polymere nicht-kovalent vernetzt und vorhandene Lösungsmittelmoleküle werden ggf. in Form eines Gels eingeschlossen.

Geeignete erste Polymere sind Polysäuren. Als organische Polysäuren kommen solche Polymere in Betracht, die eine Mehrzahl von freien Carbonsäuregruppen aufweisen. Dabei kann es sich um Homo- oder Copolymere handeln. Als carboxylgruppenhaltige bzw. carbonsäuregruppenhaltige Monomere kommen insbesondere monoethylenisch ungesättigte Mono- oder Dicarbonsäuren mit 3 bis 6 C-Atomen oder deren entsprechende Anhydride in Betracht, wie beispielsweise Acrylsäure, Methacrylsäure, Ethylacrylsäure, Allylessigsäure, Crotonsäure, Vinylessigsäure, Maleinsäure, Itaconsäure, Mesaconsäure, Furmarsäure, Citraconsäure, Methylenmalonsäure, sowie deren Partialester, wie z. B. Maleinsäuremonoalkylester, und Gemische davon. Im Falle von Dicarbonsäuremonoalkylestern bezieht sich die angegebene Anzahl an C-Atomen auf das Dicarbonsäuregerüst, die Alkylgruppe im Esterrest kann davon unabhängig 1 bis 20 C-Atome, insbesondere 1 bis 8 C-Atome aufweisen. Als entsprechende monoethylenisch ungesättigte Dicarbonsäureanhydride kommen Maleinsäureanhydrid, Itaconsäureanhydrid, Citronensäureanhydrid und deren Gemische in Betracht. Bevorzugt werden Acrylsäure, Methacrylsäure, Maleinsäure, Itaconsäure und Maleinsäureanhydrid eingesetzt.

Weitere geeignete erste Polymere sind Polystyrolsulfonsäure und deren Copolymere mit oben genannten Säuremonomeren sowie die Salze davon und die Polymere und Copolymere mit oben genannten Säuremonomeren von 2-Acrylamido-2-methylpropan-sulfonsäure sowie die Salze davon.

Besonders bevorzugt wird als erstes Polymer Poly(meth)acrylsäure eingesetzt.

Geeignete zweite Polymere sind Polyamine bzw. Polyamide. Hierzu zählen Poly-2-oxazoline, Polyalkylenpolyamine, Polyalkylenimine, Polylallylamine, Polyamidoamine, Polyvinylamine und Polyvinylpyridin.

Spezifische Beispiele sind Poly-2-methyloxazolin, Poly-2-ethyloxazolin, Tetraethylenpentamin, Pentaethylenhexamin, Polyethylenimin, Polyallylaminhydrochlorid, Poly(diallyldimethylammoniumchlorid) und das Umsetzungsprodukt von Diethylentriamin und Adipinsäure.

Das Molekulargewicht des ersten beziehungsweise zweiten Polymers liegt vorzugsweise im Bereich von 500 g/mol bis 1.000.000 g/mol, insbesondere 1.000 g/mol bis 20.000 g/mol, besonders bevorzugt 2.000 g/mol bis 8.000 g/mol.

In einer bevorzugten Ausführungsform beträgt das Verhältnis der Molmasse des ersten Polymers zur Molmasse des zweiten Polymers 1,5:1 bis 1:1,5, besonders bevorzugt 1,3:1 bis 1:1,3, ganz besonders bevorzugt 1,1:1 bis 1:1,1. In einer weiteren bevorzugten Ausführungsform werden das erste und zweite Prä-Stützmaterial in solchen Mengen ausgestoßen, dass das Gewichtsverhältnis von erstem Polymer zu zweitem Polymer mehr als 1:1 bis 20:1 oder 1:20 bis weniger als 1:1, besonders bevorzugt mehr als 1,3:1 bis 20:1 oder 1:20 bis weniger als 1:1,3, ganz besonders bevorzugt mehr als 1,5:1 bis 20:1 oder 1:20 bis weniger als 1:1,5 beträgt.

Die Polymere werden vorzugsweise als Lösungen in einem geeigneten Lösungsmittel ausgestoßen. Als Lösungsmittel kommen in Betracht Alkohole, Ester, Ketone, vorzugsweise jedoch Wasser. In einer bevorzugten Ausführungsform sind die Prä-Stützmaterialien frei von nicht-wässrigen Lösemitteln. Die Konzentration der Polymere in der Lösung liegt beispielsweise im Bereich von 2 bis 70 Gew.-%, vorzugsweise 5 bis 50 Gew.-%.

### Sekundärstützmaterial

Es ist auch möglich, das Stützmaterial in Form einer Trennschicht auszustoßen. Die eigentliche Stützung erfolgt dann durch ein Sekundärstützmaterial, wobei das Stützmaterial und das Sekundärstützmaterial wenigstens eine gemeinsame Grenzfläche aufweisen.

Bevorzugt weisen das Objektmaterial und das Sekundärstützmaterial keine gemeinsame Grenzfläche auf. In diesem Fall können Objektmaterial und Sekundärstützmaterial nach dem gleichen Mechanismus vernetzt bzw. polymerisiert werden, beispielsweise sind sowohl Objekt- als auch Sekundärstützmaterial radikalisch vernetzbar bzw. polymerisierbar. Als Sekundärstützmaterial kommen alle für den 3D-Druck bekannten Stützmaterialien in Frage, die nach der Strahlungshärtung in einem wässrigen Medium löslich sind.

Das Sekundärstützmaterial kann nach der Strahlungshärtung des Objekt- und Stützmaterials zusammen mit dem gehärteten Stützmaterial durch Behandlung mit einem wässrigen Medium, bevorzugt einem alkalisch wässrigen Medium, entfernt werden.

Das Sekundärstützmaterial ist vorteilhafterweise ein gängiges Stützmaterial für 3D-Druckverfahren. In diesen Fällen ist das Sekundärstützmaterial in der Regel kostengünstiger als das Stützmaterial. Das Auftragen des Stützmaterials als Trennschicht erlaubt dann einerseits den Erhalt exakter Konturen und einer glatten Oberfläche und gleichzeitig ein kostengünstiges Verfahren.

Das Sekundärstützmaterial kann auch ein wachsartiges Material sein, das nach dem Ausstoßen durch Abkühlung erstarrt, wie z. B. Polyethylenglycole oder ethoxylierte Fettalkohole mit geeigneten Schmelzpunkten.

Die Druckmaterialien der vorliegenden Erfindung können auch geeignete Hilfsstoffe enthalten, wie Beschleuniger, Absorber, mechanische Stabilisatoren, Pigmente, Farbstoffe, Viskositätsmodifikatoren, Mittel zum Senken der Oberflächenspannung und Benetzungshilfsmittel und Antioxidationsmittel.

### Strahlungshärtung

Das Strahlungshärten des Objektmaterials und ggf. des Sekundärstützmaterials (im Folgenden als die Druckmaterialien bezeichnet) erfolgt mit energiereichem Licht, z. B. UV-Licht oder Elektronenstrahlen, bevorzugt UV-Licht. Die Strahlungshärtung kann bei erhöhten Temperaturen erfolgen. Vorzugsweise liegt die Temperatur jedoch unterhalb der Glasübergangstemperatur T_{g} der Druckmaterialien.

Strahlungshärtung heißt hier die Vernetzung bzw. Polymerisation der radikalisch vernetzbaren bzw. kationisch polymerisierbaren Verbindungen der Druckmaterialien infolge einer elektromagnetischen und/oder korpuskularen Strahlung, bevorzugt UV-Licht im Wellenlängenbereich von λ = 200 bis 700 nm und/oder Elektronenstrahlung im Bereich von 150 bis 300 keV und besonders bevorzugt mit einer Strahlungsdosis von mindestens 80, bevorzugt 80 bis 3000 mJ/cm².

Als Strahlungsquellen für die Strahlungshärtung geeignet sind z. B. Quecksilber-Niederdruckstrahler, -Mitteldruckstrahler mit Hochdruckstrahler sowie Leuchtstoffröhren, Impulsstrahler, Metallhalogenidstrahler, Elektronenblitzeinrichtungen, wodurch eine Strahlungshärtung ohne Photoinitiator möglich ist, oder Excimerstrahler. Die Strahlungshärtung erfolgt durch Einwirkung energiereicher Strahlung, also UV-Strahlung oder Tageslicht, vorzugsweise Licht welches im Wellenlängenbereich von λ = 200 bis 700 nm strahlt, besonders bevorzugt von λ = 200 bis 500 nm und ganz besonders bevorzugt λ=250 bis 400 nm, oder durch Bestrahlung mit energiereichen Elektronen (Elektronenstrahlung; 150 bis 300 keV). Als Strahlungsquellen dienen beispielsweise Hochdruckquecksilberdampflampen, Laser, gepulste Lampen (Blitzlicht), Halogenlampen, LED-Lampen oder Excimerstrahler. Die üblicherweise zur Vernetzung ausreichende Strahlungsdosis bei UV-Härtung liegt im Bereich von 80 bis 3000 mJ/cm².

Selbstverständlich sind auch mehrere Strahlungsquellen für die Härtung einsetzbar, z. B. zwei bis vier. Diese können auch in jeweils unterschiedlichen Wellenlängebereichen strahlen.

Die Bestrahlung kann auch unter Ausschluss von Sauerstoff, z. B. unter InertgasAtmosphäre, durchgeführt werden. Als Inertgase eignen sich vorzugsweise Stickstoff, Edelgase, Kohlendioxid, oder Verbrennungsgase.

Wenn die Härtung durch UV-Bestrahlung statt Elektronenstrahlen erfolgt, so versteht es sich von selbst, dass die Druckmaterialien jeweils mindestens einen Photoinitiator bzw. Photosäuregenerator enthalten, der in einem Wellenlängenbereich der eingestrahlten Strahlung aktivierbar ist.

### 3D-Druck

Das erfindungsgemäße Verfahren wird geeigneter Weise in einer Photopolymer-Jetting-Druckanlage durchgeführt. Hier wandert ein Druckblock mit mindestens zwei Druckköpfen über einer Bauplattform vor und zurück und hinterlässt darauf dünne Schichten an photopolymerisierbaren Druckmaterialien. Die Menge an ausgestoßenen Druckmaterialien und somit die Höhe der Schichten wird über einen Regler, der an ein computerunterstütztes Konstruktions-(CAD-)System gekoppelt ist, eingestellt. Jede Schicht wird unmittelbar nach dem Auftragen mithilfe von UV-Lampen gehärtet, die direkt am Druckblock installiert sind. Die Bauplattform wird mit zunehmender Höhe der gedruckten Struktur entsprechend abgesenkt, so dass sich der Druckblock während des Druckens ausschließlich auf der x-Achse bewegt.

In einer bevorzugten Ausführungsform der Druckkopfanordnung sieht diese eine Vielzahl längs einer Linie angeordnete Druckdüsen vor, durch die das jeweils photopolymerisierbare Druckmaterial gleichmäßig verteilt ausstoßbar ist. Bevorzugt weisen die Druckköpfe mindestens 20, besonders bevorzugt 50 bis 500 Druckdüsen auf. Während des Materialaustrages wird die Druckkopfanordnung vorzugsweise orthogonal zur linienhaften Anordnung der einzelnen Druckdüsen relativ zur Arbeitsebene bewegt. Mit Hilfe einer derart ausgebildeten Druckkopfanordnung ist es möglich, auf die Bevorratung eines im flüssigen Zustand befindlichen photovernetzbaren Materials innerhalb eines Bades, wie dies beispielsweise im SL-Verfahren üblich ist, zu verzichten.

In einer Ausführungsform der vorliegenden Erfindung werden Objekt- bzw. Stützmaterial auf ein Substrat aufgetragen. Bevorzugt wird als Substrat ein steifes oder flexibles Substrat verwendet, insbesondere kann das Substrat aus einem Kunststoffmaterial hergestellt sein. In einer Ausführungsform kann das Substrat eine Plastikfolie, Plastikfilm, Membran, Glas, Metall, Halbmetall, Vlies oder Papier sein, vorzugsweise aus biokompatiblem, insbesondere bioabbaubarem Material.

In einer Ausführungsform der vorliegenden Erfindung wird das Substrat nach Abschluss der wiederholten Durchführung der Verfahrensfolgen a), b), b') und c) bzw. a), b), b'), b") und c), besonders bevorzugt im Anschluss an Schritt d), von der erhaltenen dreidimensionalen Struktur abgetrennt, insbesondere durch chemischen, physikalischen oder biologischen Abbau.

In einer weiteren Ausführungsform der vorliegenden Erfindung bleibt das Substrat nach Abschluss der wiederholten Durchführung der Verfahrensfolgen a), b), b') und c) bzw. a), b), b'), b") und c), besonders bevorzugt im Anschluss an Schritt d), Teil der hergestellten Struktur und wird so zum integralen Bestandteil der dreidimensionalen Struktur.

### Entfernen des Stützmaterials

Das gehärtete Stützmaterial und gegebenenfalls das gehärtete Sekundärstützmaterial werden durch Behandlung mit einem wässrigen Medium entfernt. Dabei wird der Verfestigsmechanismus des Stützmaterials bzw. das Sekundärstützmaterials umgekehrt und das Stützmaterial und bzw. das Sekundärstützmaterial aufgelöst. Geeigneter Weise ist das wässrige Medium ein wässrig alkalisches Medium, wie wässrige Natronlauge z. B. einer Konzentration von 0,1 bis 2 M. Alternativ ist ein wässrig saures Medium geeignet. Die erhaltene Struktur kann durch Eintauchen in das bzw. Auslaugen mit dem wässrigen Medium vom gehärteten Stützmaterial befreit werden. Alternativ kann die Struktur mit dem wässrigen Medium abgestrahlt werden.

Vorzugsweise sind die Prä-Stützmaterialien wasser-basiert. Besonders bevorzugt sind die Prä-Stützmaterialien frei von nicht-wässrigen Lösemitteln. In diesen Fällen unterscheidet sich der pH-Wert des wässrigen Mediums, mithilfe dessen die gehärteten Prä-Stützmaterialien bzw. das gehärtete Sekundärstützmaterial entfernt werden, geeigneter Weise um einen Wert von mindestens 1, bevorzugt mindestens 2, ganz besonders bevorzugt mindestens 3 vom pH-Wert des vereinigten ersten und zweiten Prä-Stützmaterials.

Die Erfindung wird anhand der beigefügten Zeichnung und der nachfolgenden Beispiele näher veranschaulicht.

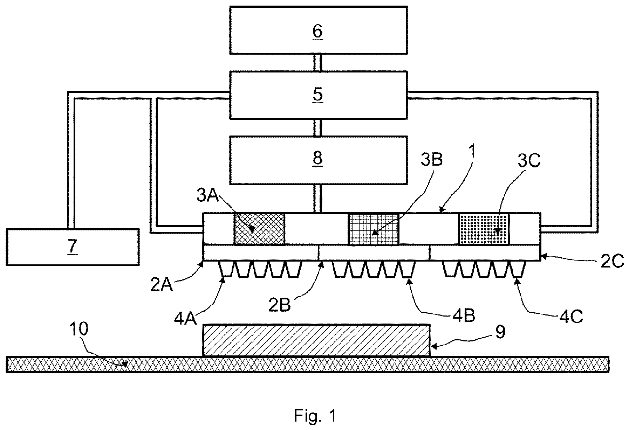

Fig. 1 ist eine schematische Darstellung einer zur Durchführung des erfindungsgemäßen Verfahrens geeigneten Anlage.

Gemäß Fig. 1 umfasst die Anlage einen Druckblock 1, welcher drei oder mehr Druccköpfe 2, die einzeln als 2A, 2B und 2C bezeichnet sind, und mindestens drei Speicherbehälter oder Spender 3, welche unterschiedliche Druckmaterialien enthalten und einzeln als 3A (Objektmaterial), 3B (erstes Prä-Stützmaterial) und 3C (zweites Prä-Stützmaterial) bezeichnet sind, enthält. Die Spender 3 können jeweils über Leitungen zu externen Reservebehältern (in Fig. 1 nicht abgebildet) befüllt werden. Andere Druckmaterialien und andere Kombinationen von Druckmaterialien können verwendet werden. Die Druckköpfe 2 weisen jeweils eine Vielzahl von Düsen auf, wie sie beispielsweise in Tintenstrahl-Verfahren verwendet werden, durch welche die Druckmaterialien 3A, 3B und 3C ausgestoßen werden.

In einer Ausführungsform der vorliegenden Erfindung ist der erste Spender, welcher Objektmaterial 3A enthält, mit einem ersten Satz von Düsen, bezeichnet als 4A, verbunden, der zweite Spender, welcher erstes Prä-Stützmaterial 3B enthält, mit einem zweiten Satz von Düsen, bezeichnet als 4B, verbunden, und der dritte Spender, welcher zweites Prä-Stützmaterial 3C enthält, mit einem dritten Satz von Düsen, bezeichnet als 4C, verbunden. Dementsprechend wird Objektmaterial 3A durch die Düsen 4A ausgestoßen, erstes Prä-Stützmaterial 3B durch die Düsen 4B ausgestoßen, und zweites Prä-Stützmaterial 3C durch die Düsen 4C ausgestoßen. In manchen Ausführungsformen umfasst das dreidimensionale Drucksystem gegebenenfalls (nicht gezeigt) mehr als drei Druckköpfe, wobei jeder Druckkopf mit einem Objektmaterial- oder (Prä-)Stützmaterial-enthaltenden Spender verbunden ist und angesteuert werden kann, um das Material im jeweiligen Spender mittels der Düsen des Druckkopfs auszustoßen. Gegebenenfalls wird mehr als ein Objektmaterial verwendet, wobei jedes Objektmaterial unter Verwendung eines verschiedenen Spenders und Druckkopfs ausgestoßen wird.

Die Druckanlage umfasst außerdem einen Regler 5, ein computerunterstütztes Konstruktions-(CAD-)System 6, eine UV-Härtungseinheit 7, und gegebenenfalls eine Positioniereinrichtung 8. Der Regler 5 ist an das CAD-System 6, die UV-Härtungseinheit 7, die gegebenenfalls umfasste Positioniereinrichtung 8, die Druckköpfe 2 und jeden der Spender 3, welche die Druckmaterialien enthalten, gekoppelt. Die Regelung kann durch von den gezeigten Einheiten abweichende bewirkt werden, z. B. ein oder mehrere separate Einheiten.

Die herzustellende dreidimensionale Struktur 9 wird in Schichten, unter Verwendung von mindestens einem der Objektmaterialien 3A, auf einer höhenverstellbaren Druckplattform 10 erzeugt, wobei die Höhe jeder Schicht typischerweise regulierbar ist, indem der Austrag der einzelnen Tintenstrahldüsen 4A selektiv eingestellt wird.

### Beispiel 1

In diesem Beispiel wurde die Eignung eines Gemischs aus einem ersten und einem zweiten Prä-Stützmaterials als Stützmaterial untersucht. Eine wässrige Lösung von statistisch copolymerisiertem 2-Ethyloxazolin und 2-Methyloxazolin (Mw: ca. 5000 g/mol)-Lösung und eine wässrige Polymethacrylsäure-Lösung (Mw: ca. 5000 g/mol) wurden in den Gewichtsverhältnissen 1:1, 2:1 und 10:1 bei jeweils verschiedenen Konzentrationen (5 bis 50 Gew.-%) zusammengegeben. Es fiel stets sofort ein Feststoff aus. Der Feststoff konnte bei erhöhtem pH-Wert (z. B. pH 8 bis 14) wieder gelöst werden.

### Beispiel 2a

Helios 1 Full Cure 525 Photopolymerjet-Tinte (enthaltend Glycerolpropoxylat(1PO/OH)-triacrylat, CAS-Nr. 52408-84-1, und einen Photoinitiator, Objekttinte) der Firma Stratasys wurde in einer Silikonform als Strang mit einem Durchmesser von ca. 1 cm neben gleichzeitig als Strang mit einem Durchmesser von ca. 1 cm aufgetragener wässriger Lösung von statistisch copolymerisiertem 2-Ethyloxazolin und 2-Methyloxazolin (Mw: ca. 5000 g/mol, 50 Gew.-%) und wässriger Polymethacrylsäure-Lösung (Mw: ca. 5000 g/mol, 25 Gew.-%) aufgetragen, so dass die beiden Stränge sich an einer Grenzfläche berührten.

Danach wurden die Materialien mit einer Hg-Lampe (365 nm) bei 30 mW/cm² für 5 min belichtet. Der Polyoxazolin-Polymethacrylsäure-Komplex wurde im wässrig-alkalischen Milieu (1 M NaOH) entfernt. Dazu wurde das wässrig-alkalische Medium in die Form gegeben, woraufhin sich das gehärtete Stützmaterial innerhalb weniger Minuten auflöste. Das wässrig-alkalische Medium wurde entnommen und das zurückbleibende Objekt mit Wasser gewaschen. Das Objekt wies keine sichtbaren Reste an Stützmaterial auf.

Es ist ersichtlich, dass die Verwendung des hier eingesetzten Stützmaterials die Erzeugung einer von Rückständen freien Objektoberfläche ermöglicht.

### Beispiel 2b

Helios 1 Full Cure 525 Photopolymerjet-Tinte (enthaltend Glycerolpropoxylat(1PO/OH)-triacrylat, CAS-Nr. 52408-84-1, und einen Photoinitiator, Objekttinte) der Firma Stratasys wurde in einer Silikonform als Strang mit einem Durchmesser von ca. 1 cm neben gleichzeitig als Strang mit einem Durchmesser von ca. 1 cm aufgetragener wässriger Lösung von statistisch copolymerisiertem 2-Ethyloxazolin und 2-Methyloxazolin (Mw: ca. 5000 g/mol, 30 Gew.-%) und wässriger Polymethacrylsäure-Lösung (Mw: ca. 5000 g/mol, 15 Gew. %) aufgetragen, so dass die beiden Stränge sich an einer Grenzfläche berührten.

Danach wurden die Materialien mit einer Hg-Lampe (365 nm) bei 30 mW/cm² für 5 min belichtet. Der Polyoxazolin-Polymethacrylsäure-Komplex wurde im wässrig-alkalischen Milieu (1 M NaOH) entfernt. Dazu wurde das wässrig-alkalische Medium in die Form gegeben, woraufhin sich das gehärtete Stützmaterial innerhalb weniger Minuten auflöste. Das wässrig-alkalische Medium wurde entnommen und das zurückbleibende Objekt mit Wasser gewaschen. Das Objekt wies keine sichtbaren Reste an Stützmaterial auf.

Es ist ersichtlich, dass die Verwendung des hier eingesetzten Stützmaterials die Erzeugung einer von Rückständen freien Objektoberfläche ermöglicht.

### Beispiel 3a

Helios 1 Full Cure 525 Photopolymerjet-Tinte (enthaltend Glycerolpropoxylat(1PO/OH)-triacrylat, CAS-Nr. 52408-84-1, und einen Photoinitiator; Objekttinte) der Firma Stratasys wurde in einer Silikonform als Strang mit einem Durchmesser von ca. 1 cm neben gleichzeitig als Strang mit einem Durchmesser von ca. 1 cm aufgetragener wässriger Lösung von statistisch copolymerisiertem 2-Ethyloxazolin und 2-Methyloxazolin (Mw: ca. 5000 g/mol, 50 Gew.-%) und wässriger Polymethacrylsäure-Lösung (Mw: ca. 5000 g/mol, 25 Gew.-%) aufgetragen, so dass die beiden Stränge sich an einer Grenzfläche berührten. Neben dem Polyoxazolin-Polymethacrylsäure-Komplex wurde Support Full Cure 705 (enthaltend Glycerolpropoxylat(1PO/OH)triacrylat, CAS-Nr. 52408-84-1, und Bis(2,4,6-Trimethylbenzoyl)phenylphosphinoxid (Irgacure 819), CAS-Nr. 162881-26-7, Sekundärstützmaterial) der Firma Stratasys aufgetragen, so dass der Polyoxazolin-Polymethacrylsäure-Komplex und Support Full Cure 705 sich an einer zweiten Grenzfläche berührten. Die Stränge wiesen eine Dicke von etwa 0,5 bis 1 mm auf.

Danach wurden die Materialien mit einer Hg-Lampe (365 nm) bei 30 mW/cm2 für 5 min belichtet. Der gehärtete Polyoxazolin-Polymethacrylsäure-Komplex bzw. Support Full Cure 705 wurden im wässrig-alkalischen Milieu (1 M NaOH) entfernt. Dazu wurde das wässrig-alkalische Medium in die Form gegeben, woraufhin sich das gehärtete Stützmaterial und das gehärtete Sekundärstützmaterial innerhalb weniger Minuten auflösten. Das wässrig-alkalische Medium wurde entnommen und das zurückbleibende Objekt mit Wasser gewaschen. Das Objekt wies keine sichtbaren Reste an Stützmaterial auf.

Es ist ersichtlich, dass die erfindungsgemäße Stützmaterialtinte auch als Schicht zwischen dem Objekt und einem gängigen Stützmaterial dienen kann.

### Beispiel 3b

Helios 1 Full Cure 525 Photopolymerjet-Tinte (enthaltend Glycerolpropoxylat(1PO/OH)-triacrylat, CAS-Nr. 52408-84-1, und einen Photoinitiator; Objekttinte) der Firma Stratasys wurde in einer Silikonform als Strang mit einem Durchmesser von ca. 1 cm neben gleichzeitig als Strang mit einem Durchmesser von ca. 1 cm aufgetragener wässriger Lösung von statistisch copolymerisiertem 2-Ethyloxazolin und 2-Methyloxazolin (Mw: ca. 5000 g/mol, 30 Gew. %) und wässriger Polymethacrylsäure-Lösung (Mw: ca. 5000 g/mol, 15 Gew. %) aufgetragen, so dass die beiden Stränge sich an einer Grenzfläche berührten. Neben dem Polyoxazolin-Polymethacrylsäure-Komplex wurde Support Full Cure 705 (enthaltend Glycerolpropoxylat(1PO/OH)triacrylat, CAS-Nr. 52408-84-1, und Bis(2,4,6-Trimethylbenzoyl)phenylphosphinoxid (Irgacure 819), CAS-Nr. 162881-26-7, Sekundärstützmaterial) der Firma Stratasys aufgetragen, so dass der Polyoxazolin-Polymethacrylsäure-Komplex und Support Full Cure 705 sich an einer zweiten Grenzfläche berührten. Die Stränge wiesen eine Dicke von etwa 0,5 bis 1 mm auf.

Danach wurden die Materialien mit einer Hg-Lampe (365 nm) bei 30 mW/cm² für 5 min belichtet. Der gehärtete Polyoxazolin-Polymethacrylsäure-Komplex bzw. Support Full Cure 705 wurden im wässrig-alkalischen Milieu (1 M NaOH) entfernt. Dazu wurde das wässrig-alkalische Medium in die Form gegeben, woraufhin sich das gehärtete Stützmaterial und das gehärtete Sekundärstützmaterial innerhalb weniger Minuten auflösten. Das wässrig-alkalische Medium wurde entnommen und das zurückbleibende Objekt mit Wasser gewaschen. Das Objekt wies keine sichtbaren Reste an Stützmaterial auf.

Es ist ersichtlich, dass die erfindungsgemäße Stützmaterialtinte auch als Schicht zwischen dem Objekt und einem gängigen Stützmaterial dienen kann.

## Patentansprüche

1. Verfahren zur Herstellung einer dreidimensionalen Struktur, das folgende Schritte umfasst:
a) Ausstoßen eines Objektmaterials aus einem ersten Druckkopf;
b) Ausstoßen eines ersten Prä-Stützmaterials aus einem zweiten Druckkopf; und b') Ausstoßen eines zweiten Prä-Stützmaterials aus einem dritten Druckkopf;
wobei die Prä-Stützmaterialien flüssige Komponenten umfassen, die beim Zusammentreffen ein festes Stützmaterial bilden;
c) Strahlungshärten des Objektmaterials;
wobei die Schritte a) bis c) mehrfach wiederholt werden, um schichtweise die dreidimensionale Struktur auszubilden und das Objektmaterial und das Stützmaterial wenigstens eine gemeinsame Grenzfläche aufweisen; und
d) Entfernen des verfestigten Stützmaterials durch Behandlung mit einem wässrigen Medium.

2. Verfahren nach Anspruch 1,
wobei die Prä-Stützmaterialien flüssige Komponenten umfassen, die beim Zusammentreffen fest werden und ein Stützmaterial in Form einer Trennschicht bilden; und das Verfahren außerdem umfasst:
b") Ausstoßen eines Sekundärstützmaterials aus einem vierten Druckkopf; wobei die Schritte a), b), b'), b") und c) mehrfach wiederholt werden, um schichtweise die dreidimensionale Struktur auszubilden und das Stützmaterial und das Sekundärstützmaterial wenigstens eine gemeinsame Grenzfläche aufweisen;
d) Entfernen des verfestigten Stützmaterials und des gehärteten Sekundärstützmaterials durch Behandlung mit einem wässrigen Medium.

3. Verfahren nach einem der vorhergehenden Ansprüche, **dadurch gekennzeichnet, dass** die Viskosität des Objektmaterials und der Prä-Stützmaterialien jeweils weniger als 20 mPas bei 70 °C beträgt.

4. Verfahren nach einem der vorhergehenden Ansprüche, **dadurch gekennzeichnet, dass** das erste Prä-Stützmaterial ein erstes Polymer, das eine Vielzahl positiv geladener Gruppen und/oder latent positiv geladener Gruppen aufweist oder eine Vielzahl an Protonenakzeptoren aufweist und das zweite Prä-Stützmaterial ein zweites Polymer, das eine Vielzahl negativ geladener Gruppen und/oder latent negativ geladener Gruppen aufweist oder eine Vielzahl an Protonendonatoren aufweist, umfasst.

5. Verfahren nach Anspruch 4, **dadurch gekennzeichnet, dass** das Verhältnis der Molmasse des ersten Polymers zur Molmasse des zweiten Polymers 1,5:1 bis 1:1,5 beträgt.

6. Verfahren nach Anspruch 5, **dadurch gekennzeichnet, dass** das Verhältnis der Molmasse des ersten Polymers zur Molmasse des zweiten Polymers 1,3:1 bis 1:1,3 beträgt.

7. Verfahren nach Anspruch 5 oder 6, **dadurch gekennzeichnet, dass** das erste und das zweite Prä-Stützmaterial in solchen Mengen ausgestoßen werden, dass das Gewichtsverhältnis von erstem Polymer zu zweitem Polymer 1:20 bis weniger als 1:1 oder mehr als 1:1 bis 20:1 beträgt.

8. Verfahren nach einem der vorhergehenden Ansprüche, **dadurch gekennzeichnet, dass** die Prä-Stützmaterialien wasser-basiert sind.

9. Verfahren nach Anspruch 8, **dadurch gekennzeichnet, dass** die Prä-Stützmaterialien frei von nicht-wässrigen Lösemitteln sind.

10. Verfahren nach Anspruch 8 oder 9, **dadurch gekennzeichnet, dass** das wässrige Medium im Schritt d) einen pH-Wert aufweist, welcher sich um mindestens 1 vom pH-Wert des vereinigten ersten und zweiten Prä-Stützmaterials unterscheidet.

## Claims

1. A process for producing a three-dimensional structure, which comprises the following steps:
a) ejection of an object material from a first printing head;
b) ejection of a first pre-support material from a second printing head; and
b') ejection of a second pre-support material from a third printing head,
where the pre-support materials comprise liquid components which on meeting form a solid support material;
c) radiation curing of the object material;
where the steps a) to c) are repeated a plurality of times in order to form the three-dimensional structure in a layerwise manner and the object material and the support material have at least one common interface; and
d) removal of the solidified support material by treatment with an aqueous medium.

2. The process according to claim 1,
wherein the pre-support materials comprise liquid components which on meeting become solid and form a support material in the form of a separating layer; and the process additionally comprises:
b'') ejection of a secondary support material from a fourth printing head;
wherein the steps a), b), b'), b'') and c) are repeated a plurality of times in order to form the three-dimensional structure in a layerwise manner and the support material and the secondary support material have at least one common interface;
d) removal of the solidified support material and the cured secondary support material by treatment with an aqueous medium.

3. The process according to either of the preceding claims, wherein the viscosity of the object material and of the pre-support materials is in each case less than 20 MPas at 70°C.

4. The process according to any of the preceding claims, wherein the first pre-support material comprises a first polymer which has a plurality of positively charged groups and/or latently positively charged groups or has a plurality of proton acceptors and the second pre-support material comprises a second polymer which has a plurality of negatively charged groups and/or latently negatively charged groups or has a plurality of proton donors.

5. The process according to claim 4, wherein the ratio of the molar mass of the first polymer to the molar mass of the second polymer is from 1.5:1 to 1:1.5.

6. The process according to claim 5, wherein the ratio of the molar mass of the first polymer to the molar mass of the second polymer is from 1.3:1 to 1:1.3.

7. The process according to claim 5 or 6, wherein the first pre-support material and the second pre-support material are ejected in such amounts that the weight ratio of the first polymer to the second polymer is from 1:20 to < 1:1 or from > 1:1 to 20:1.

8. The process according to any of the preceding claims, wherein the pre-support materials are water-based.

9. The process according to claim 8, wherein the pre-support materials are free of nonaqueous solvents.

10. The process according to claim 8 or 9, wherein the aqueous medium in step d) has a pH which differs by at least 1 from the pH of the combined first and second pre-support materials.

## Revendications

1. Procédé de fabrication d'une structure tridimensionnelle, comprenant les étapes suivantes :
a) projection d'un matériau d'objet d'une première tête d'impression ;
b) projection d'un premier précurseur de matériau d'appui d'une deuxième tête d'impression ; et
b') projection d'un second précurseur de matériau d'appui d'une troisième tête d'impression ; les précurseurs de matériau contenant des composants liquides qui forment un matériau d'appui solide à leur rencontre ;
c) photodurcissement du matériau d'objet ; les étapes a) à c) étant répétées plusieurs fois pour former la structure tridimensionnelle couche par couche, et le matériau d'objet et le matériau d'appui présentant au moins une interface commune ; et
d) élimination du matériau d'appui solidifié par traitement avec un milieu aqueux.

2. Procédé selon la revendication 1, dans lequel les précurseurs de matériau d'appui contiennent des composants liquides qui se solidifient à leur rencontre et forment un matériau d'appui sous forme d'une couche de séparation ; et le procédé comprenant en outre les étapes de :
b'') projection d'un matériau d'appui secondaire d'une quatrième tête d'impression ; les étapes a), b), b'), b'') et c) étant répétées plusieurs fois pour former la structure tridimensionnelle couche par couche, et le matériau d'appui et le matériau d'appui secondaire présentant au moins une interface commune ;
d) élimination du matériau d'appui solidifié et du matériau d'appui secondaire durci par traitement avec un milieu aqueux.

3. Procédé selon l'une des revendications précédentes, **caractérisé en ce que** les viscosités du matériau d'objet et des précurseurs de matériaux d'appui sont respectivement inférieures à 20 mPa·s à 70°C.

4. Procédé selon l'une des revendications précédentes, **caractérisé en ce que** le premier précurseur de matériau d'appui contient un premier polymère présentant plusieurs groupes chargés positivement et/ou groupes potentiellement chargés positivement ou plusieurs accepteurs de protons, et le second précurseur de matériau d'appui contient un second polymère présentant plusieurs groupes chargés négativement et/ou groupes potentiellement chargés négativement ou plusieurs donneurs de protons.

5. Procédé selon la revendication 4, **caractérisé en ce que** le rapport du poids molaire du premier polymère au poids molaire du second polymère est de 1,5:1 à 1:1,5.

6. Procédé selon la revendication 5, **caractérisé en ce que** le rapport du poids molaire du premier polymère au poids molaire du second polymère est de 1,3:1 à 1:1,3.

7. Procédé selon la revendication 5 ou 6, **caractérisé en ce que** le premier et le second précurseurs de matériau d'appui sont projetés dans des quantités dont le rapport en poids du premier polymère sur le second polymère est de 1:20 à moins de 1:1 ou de plus de 1:1 à 20:1.

8. Procédé selon l'une des revendications précédentes, **caractérisé en ce que** les précurseurs de matériau d'appui sont à base d'eau.

9. Procédé selon la revendication 8, **caractérisé en ce que** les précurseurs de matériau d'appui sont exempts de solvants non-aqueux.

10. Procédé selon la revendication 8 ou 9, **caractérisé en ce que** le milieu aqueux à l'étape d) présente un pH différent d'au moins 1 de la valeur de pH des premier et second précurseurs de matériau d'appui réunis.
